# EUROPEAN PATENT SPECIFICATION

(11) **EP 3 416 158 B1**
(45) Date of publication and mention of the grant of the patent: **23.09.2020**
(21) Application number: 18174370.9
(22) Date of filing: 25.05.2018
(51) Int. Cl.: G09G 3/3208, H01L 27/32

(54) **PIXEL ARRAY AND DISPLAY HAVING THE SAME AND ELECTRONIC DEVICE**
PIXELANORDNUNG UND ANZEIGE DAMIT UND ELEKTRONISCHE VORRICHTUNG
MATRICE DE PIXELS ET AFFICHAGE LA COMPRENANT ET DISPOSITIF ÉLECTRONIQUE

(30) Priority: 12.06.2017 CN 201710439336; 12.06.2017 CN 201720681347 U
(43) Date of publication of application: 19.12.2018
(73) Proprietor: GUANGDONG OPPO MOBILE TELECOMMUNICATIONS CORP., LTD., Wusha, Chang'an Dongguan, Guangdong 523860 (CN)
(72) Inventor: HU, Yanhao, Dongguan, Guangdong 523860 (CN)
(74) Representative: Plougmann Vingtoft a/s

(56) References cited:
- EP-A1- 2 709 090
- US-A1- 2016 253 943

## Description

### FIELD

The present disclosure relates to the display technology field, and more particularly to a pixel array and a display having the same and an electronic device.

### BACKGROUND

In a field of displays, especially in a field of active matrix organic light emitting diode display (AMOLED) technology, it is generally desired to improve a display effect by improving a pixel array. An existing arrangement of the pixel array makes pixel colors imbalanced at edges of the display, and it is difficult to obtain a balanced white at edge regions of the display.

US2016/0253943A1 provides a pixel structure. The pixel structure includes first pixel units and second pixel units that are sequentially arranged in staggered positions. The first pixel unit includes a first sub-pixel and a second sub-pixel arranged in an oblique line. The second pixel unit includes a third sub-pixel and a fourth sub-pixel arranged in an oblique line. The first sub-pixel and the third sub-pixel have different basic colors, and the second sub-pixel and the fourth sub-pixel have the same basic color.

EP2709090A1 provides an organic light emitting display device. The display device has sub-pixels of multiple colors. The organic light emitting display device detects sub-pixels which are positioned at the edges of a panel. Data for the sub-pixels on the edges are reduced so that colors on the edges are less observable.

### SUMMARY

A pixel array and a display having the pixel array provided in an embodiment of the present disclosure may improve a display effect.

A pixel array includes a plurality of pixel units. Each pixel unit includes a first sub-pixel with first color, a second sub-pixel with second color and a third sub-pixel with third color. The first sub-pixel with first color, the second sub-pixel with second color and the third sub-pixel with third color are arranged in a three-by-three pattern with three sub-pixels in each row and three sub-pixels in each column, the first sub-pixels with first color are arranged at a center and four vertexes of each pixel unit, the second sub-pixels with second color and the third sub-pixels with third color are alternately arranged at middle of boundaries of each pixel unit, adjacent pixel units are arranged to share a common boundary, characterized in that, for the pixel units located at the edges of the pixel array, the first sub-pixel with first color is absent only at the vertex or vertexes located at said edges and corresponding to said pixel units, such that the second sub-pixels with second color and the third sub-pixels with third color are alternately arranged on edges of the pixel array.

In an embodiment, the first sub-pixels with first color are arranged in a matrix, lines connecting the first sub-pixels with first color define a plurality of regular geometric patterns, and the second sub-pixels with second color and the third sub-pixels with third color are alternately arranged at geometric centers of the regular geometric patterns in each row.

In an embodiment, the first sub-pixels with first color are arranged in a matrix, lines connecting the first sub-pixels with first color define a plurality of regular geometric patterns, and the second sub-pixels with second color and the third sub-pixels with third color are alternately arranged at geometric centers of the regular geometric patterns in each column.

In an embodiment, the common boundary shared between adjacent pixel units define a first imaginary line extending in a first direction or a second imaginary line extending in a second direction, the first sub-pixels with first color and the second sub-pixels with second color are alternately arranged along the first imaginary line, and the first sub-pixels with first color and the third sub-pixels with third color are alternately arranged along the second imaginary line.

In an embodiment, the first direction is perpendicular to the second direction.

In an embodiment, the first color of the first sub-pixel is a first one of three-primary colors, the second color of the second sub-pixel is a second one of the three-primary colors, and the third color of the third sub-pixel is a third one of the three-primary colors.

In an embodiment, the first color of the first sub-pixel is green.

In an embodiment, the second color of the second sub-pixel is one of red and blue, and the third color of the third sub-pixel is the other one of red and blue.

A display is provided. The display includes a substrate, an input circuit, the above pixel array and a driving circuit. The input circuit is arranged on the substrate and is configured to receive an image. The above pixel array is arranged on the substrate. The driving circuit is arranged on the substrate and is configured to drive the pixel array to display the image.

In an embodiment, the display is an organic light emitting diode display.

An electronic device is provided. The electronic device includes a housing, a processor, a memory, a circuit board, a power supply circuit, and a display. The circuit board is enclosed by the housing. The processor and the memory are positioned on the circuit board. The power supply circuit is configured to provide power for respective circuits or components of the electronic device. The display includes the above pixel array.

In the above pixel array and display, the second sub-pixels with second color and the third sub-pixels with third color are alternately arranged at the edges of the display, such that a display defect such as a specific color stripe caused by an imbalanced pixel distribution may not appear in edge regions of the display.

### BRIEF DESCRIPTION OF THE DRAWINGS

Fig. 1 is a schematic diagram of a pixel array according to an embodiment of the present disclosure.
Fig.2 is a schematic diagram of a display according to an embodiment of the present disclosure.
Fig. 3 is a schematic diagram of an electronic device according to an embodiment of the present disclosure.

### DETAILED DESCRIPTION

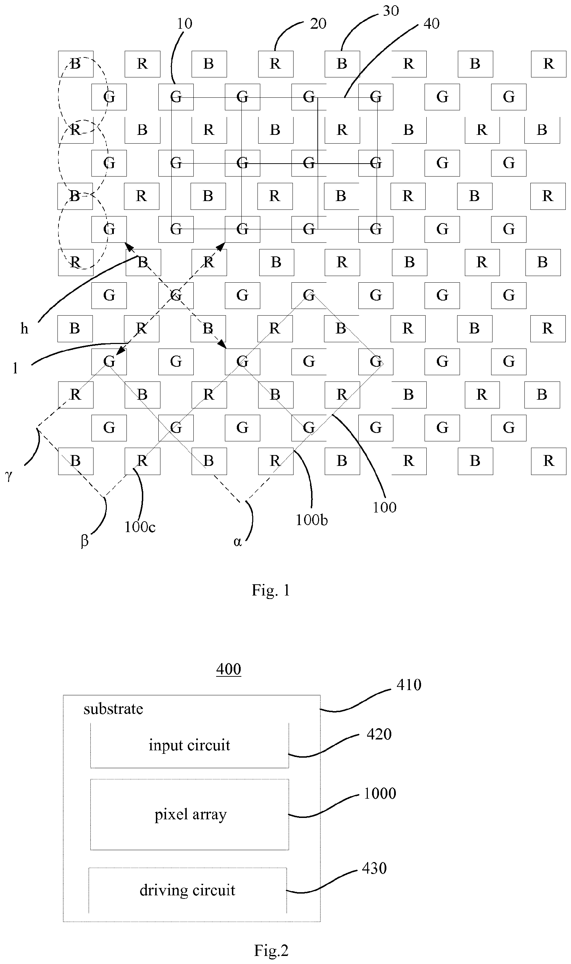

As illustrated in Fig. 1, an embodiment of the present disclosure provides a pixel array 1000. The pixel array 1000 includes a plurality of pixel units 100. Each pixel unit 100 includes a first sub-pixel with first color 10, a second sub-pixel with second color 20 and a third sub-pixel with third color 30.

The first color of the first sub-pixel 10 may be a first one of three-primary colors, the second color of the second sub-pixel 20 may be a second one of the three-primary colors, and the third color of the third sub-pixel 30 may be a third one of the three-primary colors. The three-primary colors refer to red, green and blue which can be merged to make white.

The first sub-pixel with first color 10, the second sub-pixel with second color 20 and the third sub-pixel with third color 30 are arranged in a three-by-three arrangement with three sub-pixels in each row and three sub-pixels in each column. The first sub-pixels with first color 10 are arranged at a center and four vertexes of each pixel unit 100, and the second sub-pixels with second color 20 and the third sub-pixels with third color 30 are alternately arranged at middle of boundaries of each pixel unit. The row and the column may be orthogonal or oblique to each other. Therefore, based on different arrangements, lines connecting respective sub-pixels in each pixel unit 100 may define various geometric patterns, such as rectangles, squares or rhombuses.

Adjacent pixel units 100 are arranged to share a common boundary, for example, the pixel unit 100 share a common boundary with the pixel unit 110b, as illustrated in Fig. 1. For each pixel unit 100 at an edge of the pixel array 1000, the first sub-pixel with first color 10 is absent at a vertex of the pixel unit 100, such that the second sub-pixels with second color 20 and the third sub-pixels with third color 30 are alternately arranged on the edges of the pixel array 1000. For example, as illustrated in Fig. 1, the pixel unit 100b and the pixel unit 100c are arranged at the edge of the pixel array 1000. In the pixel unit 100b, the first sub-pixel with first color 10 at the vertex indicated by α is absent. In the pixel unit 100c, the first sub-pixel with first color 10 at the vertex indicated by β and the first sub-pixel with first color 10 at the vertex indicated by γ are absent. In such pixel units 100 which are located at the edges of the pixel array 1000, the first sub-pixels with first color which are conventionally located at the edges of the pixel array 1000 are absent, such that the second sub-pixels with second color 20 and the third sub-pixels with third color 30 on the boundaries of the pixel units 100 are alternately arranged on the edges of the pixel array 1000. Therefore, at the edges of the pixel array 1000, the first sub-pixels with first color 10, the second sub-pixels with second color 20 and the third sub-pixels with third color 30 are alternately arranged to define triangular regions, as illustrated by broken circles in Fig. 1. Therefore, the first sub-pixels with first color, the second sub-pixels with second color, and the third sub-pixels with third color are distributed evenly at the edges of the pixel array 1000, thereby avoiding a poor display effect due to an imbalance of sub-pixels.

In an embodiment, the first sub-pixel with first color 10 is green. Further, the second color of the second sub-pixel 20 is one of red and blue, while the third color of the third sub-pixel 30 is the other one of red and blue. For example, the second color of the second sub-pixel 20 is red, and the third color of the third sub-pixel 30 is blue. With the above arrangement of the pixel array 1000, when it is desired to display a white color on a display having the above pixel array 1000, no color stripe of a specific color may appear in an edge region of the display, and the white color formed by evenly merging the sub-pixels is displayed.

As illustrated in Fig. 1, in an embodiment, the first sub-pixels with first color 10 are arranged in a matrix and lines connecting the first sub-pixels with first color define a plurality of regular geometric patterns 40. The second sub-pixels with second color 20 and the third sub-pixels with third color 30 are alternately arranged at geometric centers of the regular geometric patterns 40 in each row.

Further, the first sub-pixels with first color 10 are arranged in a matrix and lines connecting the first sub-pixels with first color define a plurality of regular geometric patterns 40. The second sub-pixels with second color 20 and the third sub-pixels with third color 30 are alternately arranged at geometric centers of the regular geometric patterns 40 in each column.

The regular geometric pattern 40 is symmetric, for example, may be a square, a rhombus or a rectangle.

As illustrated in Fig. 1, in each pixel unit 100, three sub-pixels are arranged on each boundary of the pixel unit 100, in which one second sub-pixel with second color 20 or one third sub-pixel with third color 30 is arranged at the middle of each boundary, and two first sub-pixels with first color 10 are arranged at two ends of each boundary, i.e., two vertexes of the pixel unit 100, respectively. The common boundary shared between adjacent pixel units 100 forms a first imaginary line 1 extending in a first direction or a second imaginary line h extending in a second direction. The first imaginary line 1 and the second imaginary line h may be perpendicular or oblique to each other according to geometric patterns defined by lines connecting respective sub-pixels in the pixel unit 100. In an embodiment as illustrated in Fig. 1, the first imaginary line 1 and the second imaginary line h are perpendicular to each other.

On the first imaginary line 1, the first sub-pixels with first color 10 and the second sub-pixels with second color 20 are alternately arranged. On the second imaginary line h, the first sub-pixels with first color 10 and the third sub-pixels with third color 30 are alternately arranged.

Embodiments of the present disclosure further provide a display 400. As illustrated in Fig. 2, the display 400 includes a substrate 410, an input circuit 420 arranged on the substrate 410, the above pixel array 1000 arranged on the substrate 410 and a driving circuit 430 arranged on the substrate 410. The input circuit 420 is configured to receive an image. The driving circuit 430 is configured to drive the pixel array 1000 to display the image. In an embodiment, the display 400 is an organic light emitting diode display. With the display 400 according to embodiments of the present disclosure, a display defect such as a specific color stripe caused by an imbalanced pixel distribution may not appear in edge regions of the display 400.

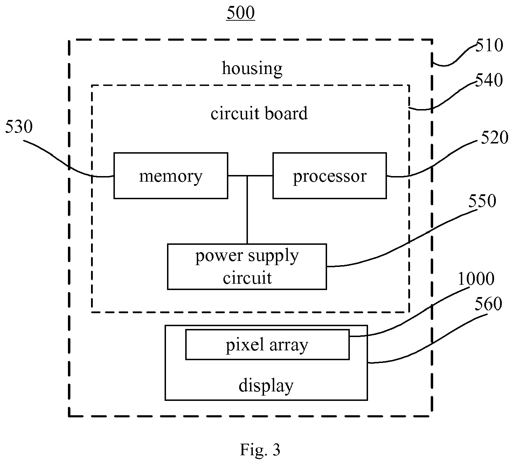

Embodiments of the present disclosure further provide an electronic device 500. As illustrated in Fig. 3, the electronic device 500 includes a housing 510, a processor 520, a memory 530, a circuit board 540, a power supply circuit 550, and a display 560. The display 560 is for example a display having the above pixel array 1000. The circuit board 540 is enclosed by the housing 510. The processor 520 and the memory 530 are positioned on the circuit board 540. The power supply circuit 550 is configured to provide power for respective circuits or components of the electronic device 500. With the electronic device 500, when an image is displayed, a display defect such as a specific color stripe caused by an imbalanced pixel distribution may not appear in edge regions of the display.

Technical features in above described embodiments may be combined arbitrarily. To make the description concise, not all possible combinations of the technical features in the above embodiments are described. However, as long as these combinations of the technical features do not contradict with each other, all of them should be considered within the scope of the specification.

The above embodiments illustrate merely some implementations of the present disclosure, which are described in details but are not construed to limit the scope of the present disclosure.

## Claims

1. A pixel array (1000), comprising a plurality of pixel units (100), each pixel unit (100) having a first sub-pixel with first color (10), a second sub-pixel with second color (20) and a third sub-pixel with third color (30), wherein the first sub-pixel with first color (10), the second sub-pixel with second color (20) and the third sub-pixel with third color (30) are arranged in a three-by-three pattern with three sub-pixels in each row and three sub-pixels in each column, the first sub-pixels with first color (10) are arranged at a center and four vertexes of each pixel unit (100), the second sub-pixels with second color (20) and the third sub-pixels with third color (30) are alternately arranged at middle of boundaries of each pixel unit (100), adjacent pixel units (100) are arranged to share a common boundary,
**characterized in that**, for the pixel units located at the edges of the pixel array (1000), the first sub-pixel with first color (10) is absent only at the vertex or vertexes located at said edges and corresponding to said pixel units, such that the second sub-pixels with second color (20) and the third sub-pixels with third color (30) are alternately arranged on edges of the pixel array (1000).

2. The pixel array (1000) according to claim 1, wherein the first sub-pixels with first color (10) are arranged in a matrix, lines connecting the first sub-pixels with first color (10) define a plurality of regular geometric patterns, and the second sub-pixels with second color (20) and the third sub-pixels with third color (30) are alternately arranged at geometric centers of the regular geometric patterns in each row.

3. The pixel array (1000) according to claim 1, wherein the first sub-pixels with first color (10) are arranged in a matrix, lines connecting the first sub-pixels with first color (10) define a plurality of regular geometric patterns, and the second sub-pixels with second color (20) and the third sub-pixels with third color (30) are alternately arranged at geometric centers of the geometric patterns in each column.

4. The pixel array (1000) according to any one of claims 1 to 3, wherein the common boundary shared between adjacent pixel units (100) define a first imaginary line extending in a first direction or a second imaginary line extending in a second direction, the first sub-pixels with first color (10) and the second sub-pixels with second color (20) are alternately arranged along the first imaginary line, and the first sub-pixels with first color (10) and the third sub-pixels with third color (30) are alternately arranged along the second imaginary line.

5. The pixel array (1000) according to claim 4, wherein, the first direction is perpendicular to the second direction.

6. The pixel array (1000) according to any one of claims 1 to 5, wherein the first color of the first sub-pixel (10) is a first one of three-primary colors, the second color of the second sub-pixel (20) is a second one of the three-primary colors, and the third of the third sub-pixel (30) is a third one of the three-primary colors.

7. The pixel array (1000) according to any one of claims 1 to 6, wherein the first color of the first sub-pixel (10) is green.

8. The pixel array (1000) according to claim 6, wherein the second color of the second sub-pixel (20) is one of red and blue and the third color of the third sub-pixel (30) is the other one of red and blue.

9. A display (400), comprising:
a substrate (410);
an input circuit (420), arranged on the substrate (410), and configured to receive an image;
a pixel array (1000) according to any one of claims 1 to 8, arranged on the substrate (410); and
a driving circuit (430), arranged on the substrate (410), and configured to drive the pixel array (1000) to display the image.

10. The display (400) according to claim 9, wherein the display (400) is an organic light emitting diode display.

11. An electronic device (500), comprising a housing (510), a processor (520), a memory (530), a circuit board (540), a power supply circuit (550), and a display (560); wherein,
the circuit board (540) is enclosed by the housing (510);
the processor (520) and the memory (530) are positioned on the circuit board (540);
the power supply circuit (550) is configured to provide power for respective circuits or components of the electronic device (500); and
the display (560) comprises a pixel array (1000) according to any one of claims 1 to 8.

## Patentansprüche

1. Pixelarray (1000), das mehrere Pixeleinheiten (100) umfasst, wobei jede Pixeleinheit (100) ein erstes Subpixel mit einer ersten Farbe (10), ein zweites Subpixel mit einer zweiten Farbe (20) und ein drittes Subpixel mit einer dritten Farbe (30) aufweist, wobei das erste Subpixel mit der ersten Farbe (10), das zweite Subpixel mit der zweiten Farbe (20) und das dritte Subpixel mit der dritten Farbe (30) in einem Drei-mal-Drei-Muster mit drei Subpixeln in jeder Zeile und drei Subpixeln in jeder Spalte angeordnet sind, wobei die ersten Subpixel mit der ersten Farbe (10) in einem Zentrum und vier Eckpunkten jeder Pixeleinheit (100) angeordnet sind, die zweiten Subpixel mit der zweiten Farbe (20) und die dritten Subpixel mit der dritten Farbe (30) alternierend in einer Mitte von Grenzen jeder Pixeleinheit (100) angeordnet sind, angrenzende Pixeleinheiten (100) so angeordnet sind, dass sie sich eine gemeinsame Grenze teilen,
**dadurch gekennzeichnet, dass** für die Pixeleinheiten, die sich an den Rändern des Pixelarrays (1000) befinden, das erste Subpixel mit der ersten Farbe (10) nur an dem Eckpunkt oder den Eckpunkten fehlt, der bzw. die sich an Rändern befindet bzw. befinden und den Pixeleinheiten entspricht bzw. entsprechen, so dass die zweiten Subpixel mit der zweiten Farbe (20) und die dritten Subpixel mit der dritten Farbe (30) alternierend an Rändern des Pixelarrays (1000) angeordnet sind.

2. Pixelarray (1000) nach Anspruch 1, wobei die ersten Subpixel mit der ersten Farbe (10) in einer Matrix angeordnet sind, Linien, die die ersten Subpixel mit der ersten Farbe (10) verbinden, mehrere regelmäßige geometrische Muster definieren und die zweiten Subpixel mit der zweiten Farbe (20) und die dritten Subpixel mit der dritten Farbe (30) alternierend an geometrischen Zentren der regelmäßigen geometrischen Muster in jeder Zeile angeordnet sind.

3. Pixelarray (1000) nach Anspruch 1, wobei die ersten Subpixel mit der ersten Farbe (10) in einer Matrix angeordnet sind, Linien, die die ersten Subpixel mit der ersten Farbe (10) verbinden, mehrere regelmäßige geometrische Muster definieren und die zweiten Subpixel mit der zweiten Farbe (20) und die dritten Subpixel mit der dritten Farbe (30) alternierend an geometrischen Zentren der geometrischen Muster in jeder Spalte angeordnet sind.

4. Pixelarray (1000) nach einem der Ansprüche 1 bis 3, wobei die gemeinsame Grenze, die zwischen angrenzenden Pixeleinheiten (100) geteilt wird, eine erste imaginäre Linie, die sich in einer ersten Richtung erstreckt, oder eine zweite imaginäre Linie, die sich in einer zweiten Richtung erstreckt, definiert, die ersten Subpixel mit der ersten Farbe (10) und die zweiten Subpixel mit der zweiten Farbe (20) alternierend entlang der ersten imaginären Linie angeordnet sind und die ersten Subpixel mit der ersten Farbe (10) und die dritten Subpixel mit der dritten Farbe (30) alternierend entlang der zweiten imaginären Linie angeordnet sind.

5. Pixelarray (1000) nach Anspruch 4, wobei die erste Richtung senkrecht zu der zweiten Richtung ist.

6. Pixelarray (1000) nach einem der Ansprüche 1 bis 5, wobei die erste Farbe des ersten Subpixels (10) eine erste von drei Primärfarben ist, die zweite Farbe des zweiten Subpixels (20) eine zweite der drei Primärfarben ist und die dritte des dritten Subpixels (30) eine dritte der drei Primärfarben ist.

7. Pixelarray (1000) nach einem der Ansprüche 1 bis 6, wobei die erste Farbe des ersten Subpixels (10) Grün ist.

8. Pixelarray (1000) nach Anspruch 6, wobei die zweite Farbe des zweiten Subpixels (20) Rot oder Blau ist und die dritte Farbe des dritten Subpixels (30) die andere von Rot und Blau ist.

9. Anzeige (400), die Folgendes umfasst:
ein Substrat (410);
einen Eingangsschaltkreis (420), der auf dem Substrat (410) angeordnet ist und zum Empfangen eines Bildes ausgebildet ist;
ein Pixelarray (1000) nach einem der Ansprüche 1 bis 8, das auf dem Substrat (410) angeordnet ist; und
einen Ansteuerungsschaltkreis (430), der auf dem Substrat (410) angeordnet ist und zum Ansteuern des Pixelarrays (1000) zum Anzeigen des Bildes ausgebildet ist.

10. Anzeige (400) nach Anspruch 9, wobei die Anzeige (400) eine organische Leuchtdiodenanzeige ist.

11. Elektronische Vorrichtung (500), die ein Gehäuse (510), einen Prozessor (520), einen Speicher (530), eine Leiterplatte (540), einen Leistungsversorgungsschaltkreis (550) und eine Anzeige (560) umfasst; wobei
die Leiterplatte (540) durch das Gehäuse (510) eingeschlossen ist;
der Prozessor (520) und der Speicher (530) auf der Leiterplatte (540) positioniert sind;
der Leistungsversorgungsschaltkreis (550) zum Bereitstellen von Leistung für jeweilige Schaltkreise oder Komponenten der elektronischen Vorrichtung (500) ausgebildet ist; und
die Anzeige (560) ein Pixelarray (1000) nach einem der Ansprüche 1 bis 8 umfasst.

## Revendications

1. Matrice (1000) de pixels, comportant une pluralité d'unités (100) de pixels, chaque unité (100) de pixel comprenant un premier sous-pixel d'une première couleur (10), un deuxième sous-pixel d'une deuxième couleur (20) et un troisième sous-pixel d'une troisième couleur (30), le premier sous-pixel de la première couleur (10), le deuxième sous-pixel de la deuxième couleur (20) et le troisième sous-pixel de la troisième couleur (30) étant disposés selon un motif trois sur trois, avec trois sous-pixels dans chaque rangée et trois sous-pixels dans chaque colonne, les premiers sous-pixels de la première couleur (10) étant disposés au centre et aux quatre sommets de chaque unité (100) de pixel, les deuxièmes sous-pixels de la deuxième couleur (20) et les troisièmes sous-pixels de la troisième couleur (30) étant disposés en alternance au milieu de frontières de chaque unité (100) de pixel, des unités (100) de pixels adjacentes étant disposées de façon à partager une frontière commune,
**caractérisée en ce que**, pour les unités de pixels situées aux bords de la matrice (1000) de pixels, le premier sous-pixel de la première couleur (10) n'est absent qu'au(x) sommet(s) situé(s) auxdits bords et correspondant auxdites unités de pixels, de telle façon que les deuxièmes sous-pixels de la deuxième couleur (20) et les troisièmes sous-pixels de la troisième couleur (30) soient disposés en alternance sur des bords de la matrice (1000) de pixels.

2. Matrice (1000) de pixels selon la revendication 1, les premiers sous-pixels de la première couleur (10) étant disposés en une matrice, des lignes qui relient les premiers sous-pixels de la première couleur (10) définissant une pluralité de motifs géométriques réguliers, et les deuxièmes sous-pixels de la deuxième couleur (20) et les troisièmes sous-pixels de la troisième couleur (30) étant disposés en alternance aux centres géométriques des motifs géométriques réguliers dans chaque rangée.

3. Matrice (1000) de pixels selon la revendication 1, les premiers sous-pixels de la première couleur (10) étant disposés en une matrice, des lignes qui relient les premiers sous-pixels de la première couleur (10) définissant une pluralité de motifs géométriques réguliers, et les deuxièmes sous-pixels de la deuxième couleur (20) et les troisièmes sous-pixels de la troisième couleur (30) étant disposés en alternance aux centres géométriques des motifs géométriques dans chaque colonne.

4. Matrice (1000) de pixels selon l'une quelconque des revendications 1 à 3, la frontière commune partagée entre des unités (100) de pixels adjacentes définissant une première ligne imaginaire s'étendant dans une première direction ou une deuxième ligne imaginaire s'étendant dans une deuxième direction, les premiers sous-pixels de la première couleur (10) et les deuxièmes sous-pixels de la deuxième couleur (20) étant disposés en alternance le long de la première ligne imaginaire, et les premiers sous-pixels de la première couleur (10) et les troisièmes sous-pixels de la troisième couleur (30) étant disposés en alternance le long de la deuxième ligne imaginaire.

5. Matrice (1000) de pixels selon la revendication 4, la première direction étant perpendiculaire à la deuxième direction.

6. Matrice (1000) de pixels selon l'une quelconque des revendications 1 à 5, la première couleur du premier sous-pixel (10) étant une première couleur parmi trois couleurs primaires, la deuxième couleur du deuxième sous-pixel (20) étant une deuxième des trois couleurs primaires, et la troisième couleur du troisième sous-pixel (30) étant une troisième des trois couleurs primaires.

7. Matrice (1000) de pixels selon l'une quelconque des revendications 1 à 6, la première couleur du premier sous-pixel (10) étant le vert.

8. Matrice (1000) de pixels selon la revendication 6, la deuxième couleur du deuxième sous-pixel (20) étant une couleur parmi le rouge et le bleu et la troisième couleur du troisième sous-pixel (30) étant l'autre couleur parmi le rouge et le bleu.

9. Afficheur (400), comportant :
un substrat (410) ;
un circuit (420) d'entrée, disposé sur le substrat (410), et configuré pour recevoir une image ;
une matrice (1000) de pixels selon l'une quelconque des revendications 1 à 8, disposée sur le substrat (410) ; et
un circuit (430) d'excitation, disposé sur le substrat (410), et configuré pour exciter la matrice (1000) de pixels afin d'afficher l'image.

10. Afficheur (400) selon la revendication 9, l'afficheur (400) étant un afficheur à diodes électroluminescentes organiques.

11. Dispositif électronique (500), comportant un boîtier (510), un processeur (520), une mémoire (530), une carte (540) à circuits, un circuit (550) d'alimentation électrique, et un afficheur (560) ;
la carte (540) à circuits étant enveloppée par le boîtier (510) ;
le processeur (520) et la mémoire (530) étant positionnés sur la carte (540) à circuits ;
le circuit (550) d'alimentation électrique étant configuré pour fournir de l'énergie à des circuits ou composants respectifs du dispositif électronique (500) ; et
l'afficheur (560) comportant une matrice (1000) de pixels selon l'une quelconque des revendications 1 à 8.
